# EUROPEAN PATENT SPECIFICATION

(11) **EP 3 666 444 B1**
(45) Date of publication and mention of the grant of the patent: **29.01.2025**
(21) Application number: 19215404.5
(22) Date of filing: 11.12.2019
(51) Int. Cl.: B23K 20/12, B64G 1/50, H05K 7/20

(54) **A METHOD OF MANUFACTURING A MULTILAYER MEMBER FOR AERONAUTIC AND AEROSPACE APPLICATIONS**
VERFAHREN ZUR HERSTELLUNG EINES MEHRSCHICHTIGEN ELEMENTS FÜR LUFT- UND RAUMFAHRTANWENDUNGEN
MÉTHODE DE FABRICATION D'UN ÉLÉMENT MULTICOUCHE POUR DES APPLICATIONS AÉRONAUTIQUES ET AÉROSPATIALES

(30) Priority: 11.12.2018 IT 201800010987
(43) Date of publication of application: 17.06.2020
(73) Proprietor: Thales Alenia Space Italia S.p.A. Con Unico Socio, 00131 Roma (IT)
(72) Inventor: SIMONE, Antonia, 10146 Torino (IT); MONTABONE, Mauro, 10146 Torino (IT); STASI, Mariassunta Francesca, 10146 Torino (IT); BERTONE, Massimo, 10146 Torino (IT)
(74) Representative: Studio Torta S.p.A.

(56) References cited:
- WO-A1-2018/219515
- US-A1- 2016 128 227
- US-A1- 2017 216 958
- MCKINLEY IAN M ET AL: "Pyrolytic graphite film thermal straps: Characterization testing", CRYOGENICS, ELSEVIER, KIDLINGTON, GB, vol. 80, 1 November 2016 (2016-11-01), pages 174 - 180, XP029824085, ISSN: 0011-2275, DOI: 10.1016/J.CRYOGENICS.2016.10.002
- DHULEY R C ET AL: "Thermal conductance characterization of a pressed copper rope strap between 0.13K and 10K", CRYOGENICS, ELSEVIER, KIDLINGTON, GB, vol. 86, 5 July 2017 (2017-07-05), pages 17 - 21, XP085166882, ISSN: 0011-2275, DOI: 10.1016/J.CRYOGENICS.2017.07.001

## Description

### Cross-Reference to Related Applications

This European patent application claims priority to Italian patent application no. 102018000010987 filed on 11/12/2018.

### Technical Field of the Invention

The present invention relates to a method of manufacturing a multilayer member for aeronautic and aerospace applications.

### State of the Art

Multilayer members for aeronautic and aerospace applications comprise thermal straps. The thermal straps used in the aeronautical and aerospace fields are generally of two types.

In a first type, the thermal strap comprises a stack of thermally conductive sheets made of a metallic material such as, for example, aluminium or copper or alloys thereof or of a non-metallic material such as, for example, graphite or graphene or carbon fibres.

The sheets have, for example, an elongated rectangular shape, and comprise a flexible central portion and two mechanical coupling interfaces on opposite sides of the central portion to enable the thermal strap to be connected to the two objects.

The sheets are mutually separated at the central portion, and are mutually connected, for example through pressing, at the mechanical coupling interfaces.

Generally, each mechanical coupling interface is connected to the corresponding object through at least one screw or clamping bolt mounted through the sheets.

In the second types, the thermal strap comprises at least one braid or strand comprising, in turn, a plurality of thermally conductive wires made of a metallic material such as, for example, aluminium or copper or alloys thereof or of a non-metallic material such as, for example, graphite or graphene or carbon fibres.

The braid or strand comprises a flexible central portion and two mechanical coupling interfaces on opposite sides of the central portion to enable the thermal strap to be connected to the two objects.

The wires are mutually separated at the central portion, and are mutually connected, for example through pressing, at the mechanical coupling interfaces.

Generally, each mechanical coupling interface is connected to the corresponding object through at least one screw or clamping bolt mounted through the wires.

WO2018219515 A1 discloses flexible connector comprising a multilayer metal strip and at least one connecting element arranged at at least one strip end, wherein the layers of the metal strip are joined together in the region of the strip end by friction welding, and a reinforcement element (6) is arranged at the strip end (2) and is bonded to the strip.

US 2016/128227 A1 discloses a heat transfer system comprising a heat source, a first heat exchanger coupled to the heat source to remove heat from the heat source, and a second heat exchanger, which is coupled to the first heat exchanger to remove heat from the first heat exchanger. The heat transfer system also comprises, furthermore, a heat duplicator coupled to the second heat exchanger to remove heat from the second heat exchanger, a first heat pipe coupled to the heat duplicator to remove heat from the heat duplicator, and a second heat pipe, which is coupled to the first heat pipe to remove heat from the first heat pipe.

US 2017/216958 A1 discloses a method of diffusion bonding and forming metallic sheets. The method comprises stacking a first metallic sheet and a second metallic sheet to define a sheet slack; creating a pneumatic seal between the first metallic sheet and the second metallic sheet to define a sealed sheet stack that defines a pneumatically isolated region; increasing a surface area of the sealed sheet stack to define an expanded sheet stack; and compressing at least a portion of the expanded sheet stack to form a diffusion bond between a corresponding portion of the first metallic sheet and an opposed portion of the second metallic sheet, thereby defining a diffusion bonded sheet stack.

The article "*Pyrolytic Graphite Film Thermal Straps: Characterization Testing"* assesses feasibility of replacing standard aluminium sheets in thermal belts with a more conductive and lighter graphite film.

The article "*Thermal conductance characterization of a pressed copper rope strap between 0.13 K and 10 K"* relates to a method of mechanical pressing the ends of a solid copper braid to build seamless conductive belts for cryogenic applications.

### Subject and Summary of the invention

Known thermal straps of the above-described type have some drawbacks mainly due to the fact that, at the mechanical coupling interfaces, each pair of adjacent sheets or wires exposes a discontinuity of material, which leads to additional thermal resistance, and limits the correct and homogeneous transmission of heat along the thermal strap.

Known thermal straps of the above-described type also have the additional drawback that the costs and time for their procurement are relatively high.

The aim of the present invention is to provide a method of manufacturing a multilayer member for aeronautic and aerospace applications.

According to the present invention, a method of manufacturing a multilayer member for aeronautic and aerospace applications is provided, as claimed in claims 1 and 2.

### Detailed Description of Preferred Embodiments of the Invention

The present invention will now be described in detail with reference to the appended figures to make it possible for persons skilled in the art relevant to the present invention to produce and use it. Various modifications to the described embodiments will be readily apparent to those persons skilled in the art, and the general principles described may be applied to other embodiments and applications without however departing from the protective scope of the present invention, as defined in the appended claims. Accordingly, the present invention is not to be limited in scope to the embodiments described and illustrated herein, but is limited by the scope of the appended claims.

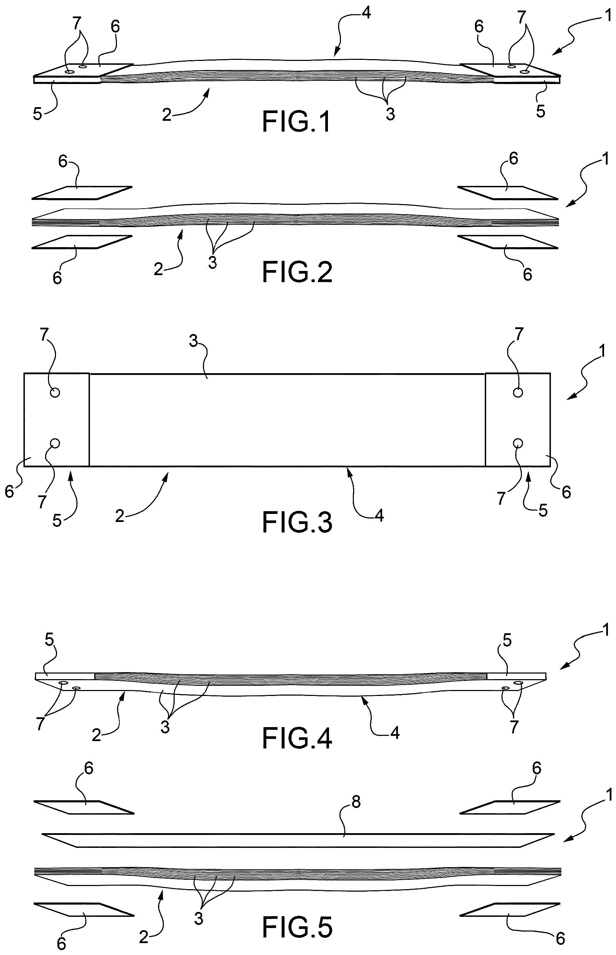

With reference to Figures 1, 2, and 3, reference numeral 1 references, as a whole, a thermal strap to mutually connect two objects (not shown), in particular two objects having different temperatures.

The thermal strap **1** comprises a stack **2** of thermally conductive sheets **3.** The stack **2** comprises a number of sheets **3** ranging between 10 to 2000, and each sheet **3** has an elongated rectangular shape and is 0.005 mm to 2 mm thick.

Sheets **3** are made of a thermally conductive metallic material such as, for example, aluminium or copper or alloys thereof, or of a thermally conductive non-metallic material such as, for example, graphite or graphene or carbon fibres.

Preferably, but not necessarily, sheets **3** are made of the same material and have the same thickness.

Thermal strap **1** further defines a flexible central portion **4,** where sheets **3** are mutually separated, i.e., they are not mutually connected, and two end portions **5** arranged on opposite sides of the flexible central portion **4.**

At each end portion **5,** sheets **3** are mutually welded and further welded to a pair of thermally conductive straps **6,** which are arranged on opposite sides of sheets **3,** are made of either the same material as, or a different material from, sheets **3,** and each of which is thicker than a sheet **3,** in particular a thickness of at least 0.8 mm.

Sheets **3** and straps **6** are mutually welded through a Friction Stir Welding (FSW) process, namely a solid state friction stir welding and remixing process wherein the material to be welded fails to reach melting temperature and the weld bead is generated by contact between a rotating welding tool, straps **6,** and sheets **3.** In particular, the welding tool comprises a shoulder, rotation of which generates friction and, hence, heat, making the material plastic; and a pin, the rotation of which remixes the plasticised material by mutually joining sheets **3** and straps **6.**

Higher thickness of straps **6** enables correct execution of the Friction Stir Welding process, avoiding any damage to and/or breakage of thinner sheets **3.**

Each end portion **5** defines a mechanical connection interface provided with a pair of coupling holes **7,** which enable end portion **5** to be connected to the corresponding object (not shown) through respective clamping screws (not shown) or respective clamping bolts (not shown) mounted through coupling holes **7.**

Obviously, the number of holes **7** in each mechanical connection interface may be different from two.

In a variant not shown, each end portion 5 is joined to only one strap **6** arranged on an end face of stack **2** where welding of sheets **3** and of strap **6** is carried out.

The variant shown in Figures 4 and 5 differs from what is shown in the previous Figures only in the thermal strap **1** further comprising an end sheet **8,** which has substantially the same shape as sheets **3,** and is interposed between the stack **2** of sheets **3** and the two straps **6.**

Sheet **8** is made of either the same material as, or a different material from, sheets **3,** and is thicker than a sheet **3.**

Sheets **3,** straps **6,** and sheet **8** are mutually welded at the two end portions **5** through Friction Stir Welding. Sheets **3** and **8** are mutually separated, i.e., they are not mutually connected, at the flexible central portion **4.**

In a variant not shown, thermal strap **1** comprises two sheets **8** arranged on opposite sides of the stack **2** of sheets **3.**

In a further variant not shown, straps **6** are removed and sheets **3** and **8** are mutually welded at the end portions **5** to define corresponding mechanical connection interfaces, and are mutually separated, i.e., they are not mutually connected, at the flexible central portion **4.**

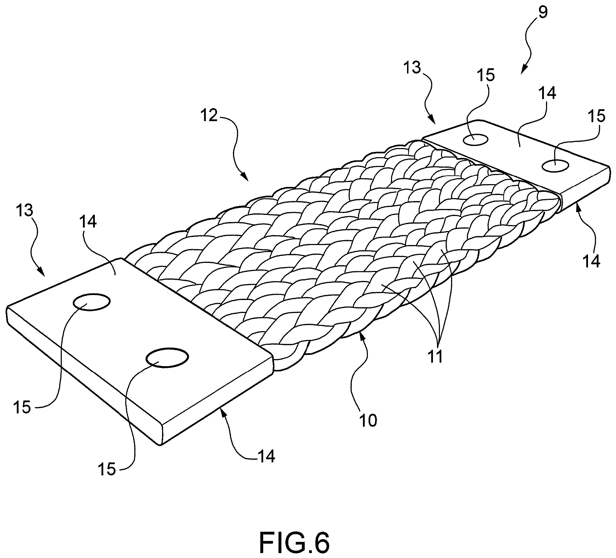

Figure 6 shows a thermal strap **9** having at least one braid or strand **10** comprising a plurality of thermally conductive wires **11** made of a metallic material such as, for example, aluminium or copper or alloys thereof, or of a non-metallic material such as, for example, graphite or graphene or carbon fibres.

Preferably, but not necessarily, wires **11** are made of the same material and have the same diameter.

Thermal strap **9** further comprises a flexible central portion **12,** at which wires **11** are mutually separated, i.e., they are not mutually connected, and two end portions **13** arranged on opposite sides of the flexible central portion **12.**

At each end portion **13,** wires **11** are mutually welded and also welded to a pair of thermally conductive straps **14,** which are arranged on opposite sides of wires **11,** are made either of the same material as, or a different material from, wires **11,** and each of which has a given thickness, in particular a thickness of at least 0.8 mm.

Wires **11** and straps **14** are mutually welded through a Friction Stir Welding process.

Each end portion **13** defines a mechanical connection interface provided with a pair of coupling holes **15,** which enable end portion **13** to be connected to the corresponding object (not shown) through respective clamping screws (not shown) or respective clamping bolts (not shown) mounted through holes **15.**

Obviously, the number of holes **15** in each mechanical connection interface may be different from two.

Welding of sheets **3** with straps **6** and/or sheet **8,** and welding of wires **11** with straps **14** enable a continuous heat path to be created within end portions **5** and **13,** so maximising heat transmission along thermal straps **1** and **9.** Flexibility of central portions **4** and **12** guarantees thermal straps **1** and **9** a relatively high versatility and ease of use.

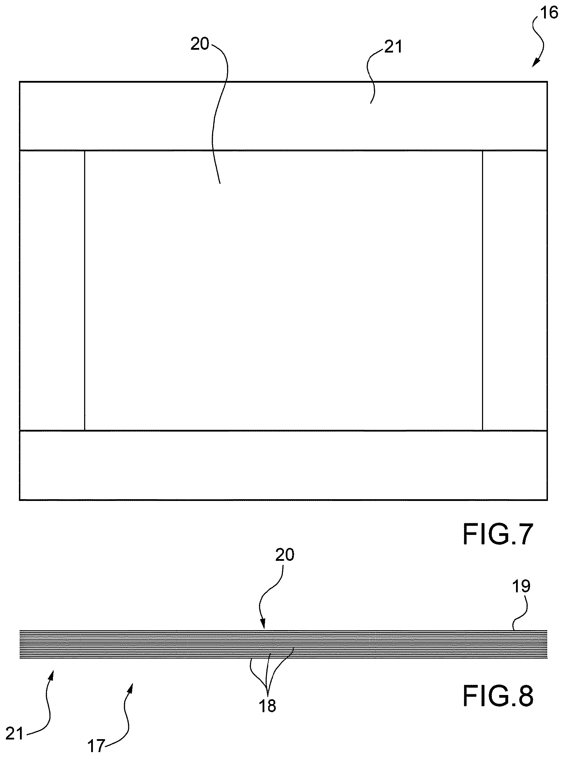

Figures 7 and 8 show a multilayer member **16** for use, for example, as a meteoritic impact protection panel.

Multilayer member **16** comprises a stack **17** of sheets **18** having, in the example shown, a quadrilateral shape. Obviously, in a variant not shown, sheets **18** may have a different shape from quadrilateral.

Stack **17** comprises a number of sheets **18** ranging between 10 to 2000 and each sheet **18** is 0.005 mm to 2 mm thick, and is made of either a metallic material such as, for example, aluminium or aluminium metallic alloys or a non-metallic material such as, for example, a polymeric material.

Preferably, but not necessarily, sheets **18** are made of the same material and have the same thickness.

Multilayer member **16** further comprises an end sheet **19,** which has substantially the same shape as sheets **18,** overlaps sheets **18,** is made of either the same material as or a different material from, sheets **18,** and is thicker than a sheet **18.**

In a variant not shown, multilayer member **16** comprises two sheets **19** arranged on opposite sides of sheets **18.**

Stack **17** comprises a central portion **20** and a perimetral edge **21** extending around at least part of portion **20.**

Sheets **18** and **19** are mutually separated, i.e., they are not mutually connected, at the central portion **20,** and are mutually welded along at least part of perimetral edge **21.**

In particular, sheets **18** and **19** are mutually welded at the perimetral edge **21** through a Friction Stir Welding process.

Higher thickness of sheet **19** enables the correct execution of the Friction Stir Welding process, so avoiding any damage to and/or breakage of thinner sheets **18.**

In a variant not shown, sheet **19** is replaced with a strap, which is arranged along perimetral edge **21,** is made of either the same material as or a different material from, sheets **18,** and is thicker than a sheet **18.**

Sheets 18 and strap are mutually welded along perimetral edge **21** through a Friction Stir Welding process and, in order to ensure relatively high flexibility of multilayer member **16,** at central portion **20.**

## Claims

1. A method of manufacturing a multilayer member (**16**) for aeronautic and aerospace applications comprising:
- forming a stack **(17)** of sheets **(18),** wherein the stack **(17)** comprises a number of sheets **(18)** ranging between 10 to 2000, and wherein each sheet **(18)** is 0.005 mm to 2 mm thick; and
- at least partially mutually welding the sheets **(18)** through Friction Stir Welding along at least part of a perimetral edge **(21)** of the stack **(17)** of sheets **(18)** to form the multilayer member (16).

2. The method according to claim 1 and comprising, furthermore, the steps of:
- arranging either an end sheet **(19)** on the stack **(17)** of sheets **(18)** or at least one end strip along at least part of the perimetral edge **(21)** of the stack **(17)** of sheets **(18);** and
- welding, along at least part of the perimetral edge **(21),** either the end sheet **(19)** or the end strip with the other sheets **(18)** to form the multilayer member **(16);**
the end sheet **(19)** or the end strip is made of the same material as, or a different material from, the other sheets **(18)** and/or with a thickness greater than the other sheets **(18).**

## Patentansprüche

1. Verfahren zur Herstellung eines mehrschichtigen Elements (16) für Luft- und Raumfahrtanwendungen, das aufweist:
- Ausbilden eines Stapels (17) von Lagen (18), wobei der Stapel (17) eine Anzahl von Lagen (18) im Bereich zwischen 10 und 2000 aufweist, und wobei jede Lage (18) 0,005 mm bis 2 mm dick ist; und
- wenigstens teilweise wechselseitiges Schweißen der Lagen (18) durch Rührreibschweißen entlang wenigstens eines Teils eines Umfangsrands (21) des Stapels (17) von Lagen (18), um das mehrschichtige Element (16) auszubilden.

2. Verfahren nach Anspruch 1, das außerdem die folgenden Schritte aufweist:
- Anordnen entweder einer Endlage (19) auf dem Stapel (17) von Lagen (18) oder wenigstens eines Endstreifens entlang wenigstens eines Teils des Umfangsrands (21) des Stapels (17) von Lagen (18); und
- Verschweißen entweder der Endlage (19) oder des Endstreifens entlang wenigstens eines Teils des Umfangsrands (21) mit den anderen Lagen (18), um das mehrschichtige Element (16) auszubilden;
wobei die Endlage (19) oder der Endstreifen aus dem gleichen Material oder einem dazu verschiedenen Material wie die anderen Lagen (18) und/oder mit einer größeren Dicke als die anderen Lagen (18) hergestellt ist.

## Revendications

1. Procédé de fabrication d'un élément multicouche (16) pour des applications aéronautiques et aérospatiales comprenant les étapes suivantes :
- former un empilement (17) de feuilles (18), dans lequel l'empilement (17) comprend un nombre de feuilles (18) compris entre 10 et 2000, et dans lequel chaque feuille (18) a une épaisseur allant de 0,005 mm à 2 mm ; et
- souder au moins partiellement mutuellement les feuilles (18) par soudage par friction le long d'au moins une partie d'un bord périmétral (21) de l'empilement (17) de feuilles (18) afin de former l'élément multicouche (16).

2. Procédé selon la revendication 1 et comprenant en outre les étapes suivantes :
- agencer soit une feuille d'extrémité (19) sur l'empilement (17) de feuilles (18) soit au moins une bande d'extrémité le long d'au moins une partie du bord périmétral (21) de l'empilement (17) de feuilles (18) ; et
- souder, le long d'au moins une partie du bord périmétral (21), soit la feuille d'extrémité (19) soit la bande d'extrémité avec les autres feuilles (18) afin de former l'élément multicouche (16) ;
la feuille d'extrémité (19) ou la bande d'extrémité est réalisée avec le même matériau ou avec un matériau différent des autres feuilles (18) et/ou avec une épaisseur supérieure aux autres feuilles (18).
